# FASCICULE DE BREVET EUROPEEN

(11) **EP 3 165 502 B1**
(45) Date de publication et mention de la délivrance du brevet: **19.12.2018**
(21) Numéro de dépôt: 16197023.1
(22) Date de dépôt: 03.11.2016
(51) Int. Cl.: B81C 3/00, C03C 3/16, C03C 17/02, C03C 27/00

(54) **DISPOSITIF MICROÉLECTRONIQUE**
MIKROELEKTRONISCHE VORRICHTUNG
MICROELECTRONIC DEVICE

(30) Priorité: 06.11.2015 FR 1560637
(43) Date de publication de la demande: 10.05.2017
(73) Titulaire: COMMISSARIAT À L'ÉNERGIE ATOMIQUE ET AUX ÉNERGIES ALTERNATIVES, 75015 Paris (FR)
(72) Inventeur: OUKASSI, Sami, 38120 SAINT-EGREVE (FR); BAILLIN, Xavier, 38920 CROLLES (FR)
(74) Mandataire: Decobert, Jean-Pascal

(56) Documents cités:
- EP-A1- 2 532 619

## Description

La présente invention concerne des dispositifs microélectroniques comportant un scellement, éventuellement réversible, à faible budget thermique. Cette invention est particulièrement intéressante dans le cas de dispositifs microélectroniques comprenant des couches sensibles à un environnement extérieur tel que par exemple l'air, l'eau ou des gaz oxydants. L'invention trouve en particulier son application dans l'assemblage tridimensionnel (3D) des dispositifs électroniques avec des fonctionnalités diverses (mécanique, optique, optoélectronique, etc.).

### ARRIERE-PLAN TECHNOLOGIQUE

D'une manière générale, les composants microélectroniques en couches minces constituent aujourd'hui encore la tête de pont du développement de l'électronique. Parmi les dispositifs les plus étudiés, les systèmes de stockage d'énergie comme les micro-batteries à base de lithium, les systèmes de récupération d'énergie comme les cellules photovoltaïques organiques et les photo-détecteurs organiques, les systèmes d'affichage comme les diodes électroluminescentes organiques ou, encore les MEMS et/ou NEMS (MEMS « Micro-electromechanical systems » et NEMS « Nano-electromechanical systems ».

Le problème commun de ces circuits et des couches actives qui les composent, réside en leur dégradation rapide notamment lorsqu'ils ne sont pas sous vide et par exemple en présence de gaz oxydants de l'atmosphère, ou d'humidité. En particulier, les MEMS et/ou NEMS nécessitent généralement d'être encapsulés sous une pression contrôlée afin d'obtenir un fonctionnement optimal (accéléromètres, gyromètres, bolomètres). Ces composants électroniques, dans leur grande majorité, embarquent des solutions d'encapsulation afin de se prémunir des éléments oxydants et corrosifs présents dans l'atmosphère environnante ou de façon générale des gaz présents dans l'atmosphère ambiante.

Le principe d'une encapsulation est généralement basé sur la réalisation d'une cavité hermétique dont l'atmosphère est contrôlée (vide, pression, gaz).

Cette encapsulation, dite hétérogène, est considérée comme l'une des solutions les plus fiables pour répondre aux besoins des dispositifs ou composants microélectroniques sensibles à l'air. Les principales motivations de ce mode d'encapsulation résident essentiellement dans sa facilité de mise en oeuvre, son faible coût et ses performances (barrière, mécanique, adhérence, thermique), en comparaison aux solutions d'encapsulation monolithiques. Dans cette technologie, le système d'encapsulation peut être réalisé séparément avant de le reporter sur le support contenant les couches actives formant le dispositif microélectronique. Ainsi, la cavité hermétique peut être définie, par exemple, par un capot reporté et scellé sur un substrat contenant des couches actives sensibles. Qu'elles soient monolithiques ou hétérogènes, la première fonction d'une solution d'encapsulation est de protéger le dispositif microélectronique de l'environnement externe.

Le collage anodique est une méthode d'assemblage rapporté en 1969 par G.D. Wallis *et al.* (Wallis G. D., Pomerantz D. J. Field assisted glass-metal sealing. J. Appl. Physics, 1969, vol. 40, n°10, pp. 3946-3949). Cette méthode s'est depuis largement développée pour des applications liées aux microcapteurs, notamment pour la réalisation de scellement hermétique ou de report de couches d'un substrat vers un autre. Le collage anodique est un procédé qui permet d'assembler de façon forte et permanente, par exemple, un élément en verre à un métal, un semi-conducteur ou un oxyde. Il est basé sur un mécanisme électrochimique de formation de liaisons covalentes à partir des anions d'oxygène O₂⁻. Dans la pratique, il s'agit de mettre en contact deux surfaces, par exemple verre et silicium. A une température comprise entre 200°C et 500°C et en appliquant une forte tension négative sur le verre (200-1000V), on provoque la migration des ions Na⁺ et O₂⁻. Les anions d'oxygène peuvent alors réagir avec le silicium pour former des liaisons Si-O-Si.

Les principaux paramètres du procédé de collage anodique sont : la tension appliquée à la structure, par exemple de l'ordre de 1000 volts, la température de collage, par exemple entre 200°C et 500°C, la composition du verre, l'état de surface des éléments à assembler, la pression appliquée pour la mise en contact des éléments à coller.

Le collage anodique présente plusieurs avantages, par exemple les excellentes propriétés mécaniques du collage permanent induit, ainsi que le niveau élevé d'herméticité obtenu dans les scellements sous vide réalisés par cette technique. Le document EP2532619 A1 présente également un procédé de soudure anodique.

Néanmoins le collage anodique présente certains inconvénients, dont les niveaux élevés de tension et de température appliqués. Les valeurs élevées de ces paramètres empêchent une compatibilité du procédé de collage anodique avec la réalisation de composants sensibles (qui se dégradent à des températures élevées et/ou sous l'action de champs électriques importants), par exemple des micro-batteries, des composants électrochromes, des diodes électroluminescentes organiques, etc.

L'état de l'art présente principalement deux approches adoptées dans le but de réduire la tension et/ou la température. Une première approche consiste à réduire le chemin parcouru par les ions au cours du procédé. Ce procédé revient à réduire l'épaisseur du verre (amincissement) ou à utiliser une couche mince du verre considéré (dépôt). Ceci nécessite une réduction de la tension nécessaire au collage anodique. Une approche additionnelle ou complémentaire à la précédente, consiste à sélectionner un ion à plus forte mobilité dans la matrice de verre (pour une température donnée), par exemple Li⁺ au lieu de Na⁺. Ceci revient à abaisser la température de collage.

Le document US6660614B2 décrit une méthode de collage anodique entre un substrat de verre et un substrat semi-conducteur comportant une étape d'immersion du substrat de verre dans un bain de sels fondus afin de réaliser un échange ionique Na⁺/Li⁺. La méthode décrite permet ainsi de remplacer de manière locale des ions Na⁺ par des ions Li⁺ présentant une mobilité plus importante dans le verre. Cette méthode permet de réaliser des collages à des températures entre 200 et 250°C, en appliquant des tensions entre 760 et 2000 Volts. Ces valeurs demeurent néanmoins élevées par rapport aux spécifications des composants sensibles.

Le document US8481441B2 décrit, quant-à-lui, une méthode de collage anodique mettant en oeuvre un des deux substrats en une céramique présentant des ions Li⁺ et non pas Na⁺. Il est question ici de remplacer de manière totale des ions classiques, en général Na⁺, par des ions présentant une mobilité plus élevée, en l'occurrence Li⁺. Cette méthode permet de réaliser des collages à des températures de l'ordre de 300°C, plus élevées que les limites de certains composants sensibles.

Le document de Tiwari et al, J. Nano- Electron. Phys. 3 (2011) No1, P. 418-425 décrit une méthode de collage anodique de deux substrats en silicium en utilisant une couche intermédiaire de 3 microns de verre borosilicate de type Pyrex. Dans cette approche, il est question de réduire l'épaisseur du verre. Cette méthode permet notamment de réaliser des collages anodiques à 400°C, en appliquant des tensions aussi faibles que 50 Volts. Les températures demeurent dans ce cas élevées, pour une compatibilité avec des composants sensibles.

Le document US6617264B1 décrit une couche de SOG (acronyme pour « spin on glass » en anglais) comportant plusieurs éléments - notamment des ions de métaux alcalins (dont Li, Na, ou K) - et qui est utilisé comme couche intermédiaire pour collage anodique. Cette approche combine les effets de réduction d'épaisseur de verre et de sélection d'ions à forte mobilité. La méthode décrite permet d'obtenir des collages à des températures entre 300° et 350°C, c'est-à-dire bien plus élevées que les spécifications ciblées.

La solution décrite dans l'invention propose de remédier entre autres, au moins en partie, à ces problèmes. Ainsi, un objet de la présente invention est de prévoir un procédé de réalisation d'un système d'encapsulation palliant au moins en partie certains des inconvénients des procédés existants. En particulier, un objet de la présente invention est de décrire une méthode de collage anodique compatible avec la réalisation de composants sensibles.

### RESUME DE L'INVENTION

La présente invention concerne, suivant un aspect, un dispositif microélectronique comprenant : un premier support, un deuxième support, des premières faces respectives des premier et deuxième supports étant disposées en regard, et une couche de scellement entre lesdites premières faces.

De manière particulièrement avantageuse, la couche de scellement comprend au moins une couche d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1.

La présente invention concerne également, suivant certains aspects, un procédé de réalisation d'un dispositif microélectronique comprenant un premier support, un deuxième support, des premières faces respectives des premier et deuxième supports étant disposées en regard, le procédé comprenant une étape de formation d'une couche de scellement entre lesdites premières faces. De manière particulièrement avantageuse, la couche de scellement comprend au moins une couche d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1.

La présente invention concerne également l'utilisation d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1, comme couche de scellement pour l'assemblage d'un premier support et d'un deuxième support.

Un aspect de la présente invention consiste ainsi à réaliser un collage anodique en utilisant une couche de scellement conductrice ionique, de formule LiₓP_{y}O_{z}N_{w}. Avantageusement, l'utilisation de cette couche conductrice ionique permet de réduire l'épaisseur du support, par exemple en verre, tout en augmentant la mobilité des ions associés (en l'occurrence les ions lithium Li⁺).

L'introduction de la couche de scellement dans le procédé de collage anodique selon la présente invention apporte un certain nombre d'avantages parmi lesquels : une conductivité ionique élevée à température ambiante (typiquement entre 0.5 à 3 µS.cm⁻¹ pour Li⁺) environ 100 fois supérieure à celle de l'art antérieur, une compatibilité chimique des supports (par exemple, en verre, en silicium ou en matériaux semi-conducteurs), une possibilité d'ajustement du coefficient d'expansion thermique en fonction de la composition (par exemple, de l'azote N dans le composé LiₓP_{y}O_{z}N_{w}), ainsi qu'une compatibilité avec des étapes de dépôt/structuration standards du domaine de la microélectronique.

De par sa conductivité ionique élevée, la couche de scellement permet d'avoir une mobilité élevée des ions Li⁺. Cette caractéristique du matériau, associée à sa configuration en couche mince, a pour conséquence de diminuer la température et la tension appliquées au cours du procédé de collage anodique. La mobilité des ions est certes très élevée à température ambiante, ce qui limite le besoin de chauffer pendant le collage. Par ailleurs, la tension nécessaire à la réaction électrochimique est faible dans la mesure où la migration se fait à l'échelle de la couche mince et non pas à l'échelle d'un substrat massif.

De manière particulièrement avantageuse, la présente invention permet de réaliser un collage anodique à des températures et des tensions plus faibles que celles requises dans l'art antérieur. En particulier, le collage anodique est, par exemple, réalisé à une température inférieure à 150°C, pour une tension inférieure à 100 volts.

La présente invention propose une solution d'encapsulation des dispositifs sensibles à l'air basée sur le principe de cavité hermétique palliant au moins en partie les inconvénients de l'art antérieur. Ainsi, la présente invention permet une encapsulation performante, sans détérioration du composant encapsulé, tout en facilitant les étapes d'intégration et d'assemblage du dispositif.

### BREVE INTRODUCTION DES FIGURES

D'autres caractéristiques, buts et avantages de la présente invention apparaîtront à la lecture de la description détaillée qui suit, en regard des dessins annexés, donnés à titre d'exemples, non limitatifs, et sur lesquels :
- La FIGURE 1A illustre une vue en coupe d'un premier support sur lequel est déposée une couche de scellement.
- La FIGURE 1B illustre une vue en coupe d'un premier support et d'un deuxième support séparés par une couche de scellement.
- La FIGURE 2 illustre une vue en coupe d'un premier support sur lequel est positionné un composant, et d'un deuxième support, séparés par une couche de scellement ; le composant étant encapsulé dans une cavité délimitée par le premier support, le deuxième support et la couche de scellement.
- La FIGURE 3 illustre une vue en coupe d'un mode de réalisation particulier illustrant la présence d'une couche barrière positionnée sur les flancs de la couche de scellement internes et externes à la cavité.
- La FIGURE 4 illustre une vue en coupe d'un mode de réalisation particulier illustrant une pluralité de couches barrières.
- La FIGURE 5 illustre une vue en coupe d'un mode de réalisation particulier où la couche de scellement présente un gradient de sa composition chimique évoluant relativement à son épaisseur.
- La FIGURE 6 illustre une vue en coupe d'un mode de réalisation particulier où un deuxième support est séparé du premier support par une première couche de scellement et un deuxième support additionnel est séparé du premier support par une deuxième couche de scellement.
- Les figures 7a, 7b et 7c illustrent un autre mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- Le dispositif est tel que l'un au moins parmi le premier support 1 et le deuxième support 2 porte sur sa première face au moins un composant électronique 3;
- il comprend une cavité 9 hermétique délimitée par la première face du premier support 1, la première face du deuxième support 2 et la couche de scellement 4, ledit au moins composant électronique 3, étant encapsulé dans ladite cavité 9;
- la cavité 9 comprenant un élément absorbeur getter ;
- le composant électronique 3 comporte une couche de LiₓP_{y}O_{z}N_{w} formée à partir d'une même couche d'un matériau conducteur ionique de formule LiₓP_{y}O_{z}N_{w} que la couche de scellement 4, de préférence pour former l'un parmi : une microbatterie, un composant électrochrome ;
- la couche de scellement 4 forme un contour fermé ;
- le dispositif comprend une couche barrière 5 ; au moins une portion de la couche barrière 5 étant disposée sur un flanc externe de la couche de scellement 4 ;
- une portion de la couche barrière 5 est disposée sur un flanc interne de la couche de scellement 4;
- la couche barrière 5 comprend un matériau diélectrique isolant ;
- une couche barrière intermédiaire 6 est positionnée entre deux portions de la couche de scellement 4;
- l'un au moins parmi les paramètres x, y, z, w du composé LiₓP_{y}O_{z}N_{w} est évolutif dans l'épaisseur de la couche de scellement 4 ;
- un gradient de composition w/y évolue d'une valeur minimale au niveau d'une interface de collage de la couche de scellement 4 en contact avec l'un parmi le premier et le deuxième supports 1, 2 ayant le coefficient d'expansion thermique le plus élevé vers une valeur maximale au niveau d'une interface de collage de la couche de scellement en contact avec l'autre support parmi le premier et le deuxième supports 1, 2 ayant le coefficient d'expansion le moins élevé.
- Le dispositif comprend une deuxième couche de scellement 42 pour assembler le premier support 1 avec un deuxième support additionnel 22; la deuxième couche de scellement 42 comprend au moins une couche d'un matériau conducteur ionique de formule Liₓ₁P_{y1}O_{z1}N_{w1}, avec x1 strictement supérieur à 0 et inférieur ou égal à 4.5, y1 strictement supérieur à 0 et inférieur ou égal à 1, z1 strictement supérieur à 0 et inférieur ou égal à 5.5, w1 supérieur ou égal à 0 et inférieur ou égal à 1 ;
- la couche de scellement 4 et la deuxième couche de scellement 42 ont des compositions chimiques différentes ;
- la deuxième couche de scellement 42 a une épaisseur inférieure à 5 microns, de préférence inférieure à 2 microns ;
- la couche de scellement 4 a une épaisseur inférieure à 5 microns, de préférence inférieure à 2 microns ;
- au moins un support parmi le premier support 1 et le deuxième support 2 présente un creux sur sa première face.
- le premier support 1 et/ou le deuxième support 2 sont/est formé(s) en un matériau à base de verre, de semi-conducteur dopé ou non-dopé, de métal ou d'un semi-conducteur comprenant une couche métallique.
- après la formation de la couche de scellement 4, on effectue un collage anodique en appliquant une tension inférieure à 100 volts et/ou une température inférieure à 150°C ;
- l'étape de formation de la couche de scellement est configurée de sorte à former une cavité 9 hermétique délimitée par la première face du premier support 1, la première face du deuxième support 2 et la couche de scellement 4;
- l'un au moins parmi le premier support 1 et le deuxième support 2 porte sur sa première face au moins un composant électronique 3, de sorte le composant 3 soit encapsulé dans ladite cavité 9 ;
- on forme au moins une couche du composant 3 à partir de la couche d'un matériau conducteur ionique de formule LiₓP_{y}O_{z}N_{w} de la couche de scellement 4.
- on forme dans la cavité 9, un élément absorbeur getter ;
- l'étape de formation de la couche de scellement 4 comprend la formation d'une couche barrière 5; la couche barrière 5 étant disposée sur un flanc externe de la couche de scellement 4.
- la couche barrière 5 est disposée sur un flanc interne de la couche de scellement 4;
- on forme une couche barrière intermédiaire 6 de sorte à ce qu'elle soit positionnée entre deux portions de la couche de scellement 4;
- l'un au moins parmi les paramètres x, y, z, w du composé LiₓP_{y}O_{z}N_{w} est évolutif dans l'épaisseur de la couche de scellement 4 ;
- on forme un gradient de composition w/y qui évolue d'une valeur minimale au niveau d'une interface de collage de la couche de scellement 4 en contact avec l'un parmi le premier et le deuxième supports ayant le coefficient d'expansion thermique le plus élevé vers une valeur maximale au niveau d'une interface de collage de la couche de scellement en contact avec l'autre support parmi le premier et le deuxième supports ayant le coefficient d'expansion le moins élevé.
- on forme une deuxième couche de scellement pour assembler le premier support avec un deuxième support additionnel; la deuxième couche de scellement comprend au moins une couche d'un matériau conducteur ionique de formule Liₓ₁P_{y1}O_{z1}N_{w1}, avec x1 strictement supérieur à 0 et inférieur ou égal à 4.5, y1 strictement supérieur à 0 et inférieur ou égal à 1, z1 strictement supérieur à 0 et inférieur ou égal à 5.5, w1 supérieur ou égal à 0 et inférieur ou égal à 1 ;

Il est précisé que, dans le cadre de la présente invention, le terme « sur » ne signifie pas obligatoirement « au contact de ».

Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

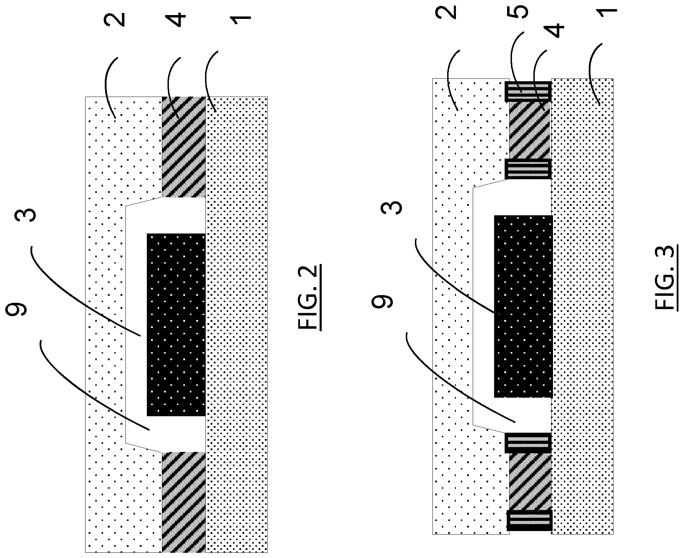

Il est également précisé que, dans le cadre de la présente invention, l'épaisseur d'une couche se mesure selon une direction perpendiculaire à la surface selon laquelle cette couche présente son extension maximale. Typiquement, lorsque les couches forment des portions de cylindre, leur épaisseur est prise selon une direction perpendiculaire aux deux faces formant des disques. Sur la figure 2 par exemple, l'épaisseur est prise selon la verticale.

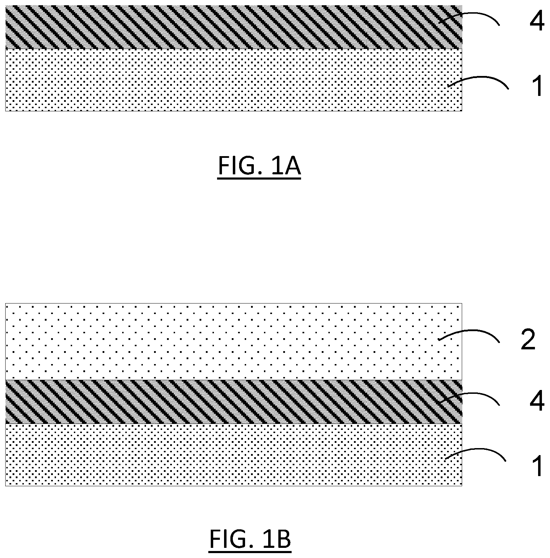

L'invention concerne un procédé de réalisation d'un dispositif microélectronique, en référence aux figures 1 à 6. Selon l'invention, on entend par dispositif microélectronique, un dispositif comportant des éléments de dimensions microniques et/ou nanométriques. Un tel dispositif peut comporter ou non un ou plusieurs composants. Il peut aussi s'agir d'un assemblage de supports à base de couches dont par exemple une partie est en matériau(x) semi-conducteur(s).

La **figure 1A** illustre une vue en coupe d'un premier support 1 sur une première face duquel est déposée une couche de scellement 4. On entend préférentiellement par support, un substrat, une puce ou une plaque (plus communément dénommée « wafer », en anglais) comprenant au moins une puce. On entend en particulier tout substrat qui comprend au moins un élément électronique. Le premier support 1 peut, par exemple, comprendre du silicium, du silicium dopé, un semiconducteur, du verre, un métal ou un substrat isolant présentant un dépôt métallique en surface.

Avantageusement, la couche de scellement 4 comprend au moins une couche d'un matériau conducteur ionique, de formule LiₓP_{y}O_{z}N_{w} avec 0<x≤4.5, 0<y≤1, 0<z≤5.5 et 0≤w≤1. La couche de scellement 4 présente possiblement une épaisseur inférieure à 5 µm, de préférence inférieure à 2 µm. A titre préféré, cette couche de scellement 4 présente une épaisseur comprise entre 0.1 et 5 microns. La couche de scellement 4 est réalisée notamment par des techniques de dépôt telles que : le dépôt par pulvérisation réactive, l'ablation laser, le dépôt chimique en phase vapeur (acronyme CVD en anglais pour « chemical vapor déposition »), le dépôt chimique en phase vapeur assisté par plasma (acronyme PECVD en anglais pour « plasma enhanced chemical vapor déposition »), le dépôt chimique métallo-organique en phase vapeur (acronyme MOCVD en anglais pour « metal organic chemical vapor déposition »), ou encore le dépôt par sol-gel.

Une deuxième étape consiste à mettre en contact le premier support 1 recouvert de la couche de scellement 4 avec un deuxième support 2. La **figure 1B** illustre une vue en coupe d'un premier support et d'un deuxième support séparés par une couche de scellement 4.

Le deuxième support 2 peut, par exemple, comprendre du silicium, du silicium dopé, un semi-conducteur, du verre, un métal ou un substrat isolant présentant un dépôt métallique en surface.

On procède ensuite à un collage anodique en appliquant une faible tension, de préférence inférieure à 100 volts, et/ou une faible température, de préférence inférieure à 150°C.

Les premier et deuxième supports 1, 2 peuvent être un substrat passif sans couche active, un substrat avec éléments électriques ou bien un substrat avec un ou plusieurs composants de même nature ou de natures différentes. Le critère prédominant dans le choix des matériaux constituant les supports 1, 2 est dicté par les propriétés barrières requises par l'application visée. Ces supports 1, 2 d'une épaisseur préférentiellement inférieure à 100 microns peuvent être de nature métallique, céramique, verre ou tout autre matériau ou combinaisons de matériaux permettant de garantir si besoin est une étanchéité suffisante vis-à-vis des espèces oxydantes telles que par l'exemple : l'eau H₂O ou/et l'oxygène O₂, ou/et l'azote N₂, ou/et les gaz rares

En fonction de l'application visée, d'autres critères d'ordre optique (transparence et transmittance), thermique, chimico-physique (résistance à la corrosion) ou mécanique peuvent être exigés. De manière préférée, les supports 1, 2 sont choisis dans la large gamme des différentes familles de verres (borofloat, borosilicates ou leurs dérivés), à des épaisseurs notamment inférieures ou égale à 100 microns.

Sur le mode de réalisation de la figure 1B le dispositif de l'invention ne comporte pas de cavité. La couche de scellement est pleine couche et permet de sceller les deux supports. L'objectif de l'invention peut résider dans ce scellement, sans formation de cavité. La couche de scellement peut par exemple être pleine plaque ou former tout contour fermé ou non adapté au scellement. Ce scellement peut-être bien entendu réversible et on peut dissocier les 2 supports en utilisant des contraintes mécaniques et/ou en utilisant un traitement thermique approprié et/ou par gravure chimique et/ou par ablation laser de la couche de scellement.

Selon un mode de réalisation préféré mais non limitatif de l'invention, au moins un composant 3 est formé dans le dispositif. Les étapes de réalisation d'un dispositif électronique, comprenant au moins un composant 3, par exemple de type micro-batterie au lithium, peuvent être effectuées comme cela est illustré sur les figures 2 à 6.

D'une manière générale, le composant 3 (par exemple, une micro-batterie) est réalisé par des techniques connues dans l'état de l'art antérieur. Les dimensions et les épaisseurs des couches constituant le composant 3, sont données à titre illustratif pour représenter les principes de l'invention. La description donnée dans la suite de ce document fera référence à un dispositif particulier de micro-batterie au lithium, étant entendu que cet exemple est donné à titre illustratif et non limitatif. Il peut être transposé à tout composant électronique, optique, optoélectronique, micromécanique ou autre. Selon des modes de réalisation particuliers, le composant 3 est choisi parmi une microbatterie, un composant électrochrome, un micro-capteur, ou un autre composant qui intègre une couche de scellement, de préférence de formule LiₓP_{y}O_{z}N_{w} dans sa structure.

Sur la **figure 2**, le composant 3 est encapsulé dans une cavité hermétique 9 délimitée par la première face du premier support 1, la première face du deuxième support 2 et la couche de scellement 4. Avantageusement, au moins un support parmi le premier support 1 et le deuxième support 2 est creux. L'assemblage constitué par le premier support 1 et le deuxième support 2 est un ensemble solide mécaniquement. Les couches actives du composant 3 sont emprisonnées dans une cavité 9 parfaitement hermétique définie par une jointure entre le premier support 1 et le deuxième support 2. Optionnellement, la cavité 9 engendrée par le scellement du deuxième support 2 sur le premier support 1, comprenant le composant 3, peut être contrôlée en atmosphère, en réalisant les procédés de scellement sous gaz inerte (comme l'argon) ou sous vide. Un matériau absorbeur (en anglais « getter ») peut être employé pour absorber au moins en partie des espèces gazeuses telles l'oxygène et/ou l'azote. Notamment, pour obtenir une pression contrôlée (nature et pression partielle des gaz), on peut ajouter un dépôt de matériau getter de préférence métallique en couche mince de type NEG (« Non Evaporable getter »). L'épaisseur de celui-ci peut être comprise entre 0.2 et 2 µm et sa composition est choisie de façon à ce qu'il soit thermiquement activable à une température compatible avec le dispositif 3. A titre d'exemple un alliage ternaire Ti-Zr-V pourra être activé à une température proche de 150°C, alors qu'un alliage binaire à base de Ti et/ou Zr sera activable à plus haute température, mais inférieure à 400°C.

Dans le cadre de cette invention, le procédé de report du deuxième support 2 sur le premier support 1 est rendu possible par l'utilisation des techniques de scellement. Le principe est de doter le premier support 1 d'une couche de scellement 4 de manière homogène ou sous forme de micro-cordon ou cordon de scellement, avant de figer mécaniquement le deuxième support 2 sur le premier support 1. Avantageusement, le matériau de scellement est conçu sous forme de cordon de scellement en périphérie du premier support 1, de façon à entourer le composant 3 sensible. La couche de scellement 4 forme avantageusement un contour fermé autour de l'au moins un composant 3. Avantageusement, la couche de scellement 4 est formée en un matériau isolant électriquement. La forme, la hauteur, la longueur et la largeur de la couche de scellement 4 sont des paramètres qui peuvent être ajustés en fonction de la nature des dispositifs ou composants microélectroniques.

Selon un mode de réalisation de l'invention, l'épaisseur de la couche de scellement 4 est avantageusement choisie de sorte à créer une cavité 9 entre le premier support 1 et le deuxième support 2 nécessaire pour une fonctionnalité électrique correcte sans altérer les propriétés électriques du composant 3, par exemple une batterie. La hauteur d'une telle cavité 9 est définie par la différence entre l'épaisseur de la couche de scellement 4 et celle du composant 3, formant par exemple une batterie. Typiquement, la valeur minimale de cette hauteur est fixée autour de 5% de la valeur de l'épaisseur totale du composant 3. Les dimensions (l'épaisseur notamment) de la couche de scellement 4, préconisées dans les exemples de réalisation, peuvent être ajustées selon les applications. Cependant, il faudra veiller à préserver les propriétés barrières et de robustesse mécanique.

Cette couche de scellement 4 peut être réalisée sur le premier support 1 contenant le composant 3, ou alternativement sur le deuxième support 2, en utilisant les différentes techniques connues dans l'état de l'art. A titre indicatif, la dispense ou la sérigraphie sont les techniques préférentielles les plus compatibles au regard des dimensions et des architectures requises pour la couche de scellement 4.

Selon les principes préconisés dans le cadre de cette invention, la couche de scellement 4 entoure et délimite les parties actives du composant 3.

De plus, cette solution garantit une robustesse mécanique accrue de l'ensemble constitué par le dispositif microélectronique et son packaging. Cet avantage majeur trouve son application dans les procédés d'assemblage tridimensionnel des composants microélectroniques en général et plus particulièrement les composants réalisés à partir de substrats ultrafins (épaisseur inférieure à 50 microns) nécessitant l'emploi des capots d'encapsulation ultrafins, tels que le deuxième support 2.

Avantageusement, le scellement par collage anodique permet de réaliser un scellement hermétique du composant 3 sensible, sans dégrader les performances dudit composant 3.

Le scellement par collage anodique est une méthode simple et robuste qui offre une solution très prometteuse pour l'encapsulation des dispositifs microélectroniques. L'un des principaux avantages de cette technique est lié à sa facilité de mise en oeuvre indépendamment de la planéité des surfaces à coller en raison de ses fortes capacités de mouillage. D'une manière générale, l'étanchéité de la couche de scellement 4 est le premier critère recherché pour la solution d'encapsulation par report d'un deuxième support 2.

Selon un mode de réalisation particulier illustré en **figure 3**, une couche barrière 5 est disposée sur au moins un des flancs de la couche de scellement 4. De préférence, la couche barrière 5 forme au moins une portion ayant un contour fermé fermant le flanc de la couche de scellement 4 entre les premières faces des supports 1, 2. Selon un mode de réalisation, la couche barrière 5 est disposée sur le flanc de la couche de scellement 4 externe à la cavité 9. Selon un autre mode de réalisation, la couche barrière 5 est disposée sur le flanc de la couche de scellement 4 interne à la cavité 9. A titre préféré, la couche barrière 5 est positionnée en deux portions de part et d'autre de la couche de scellement 4, autrement dit sur les flancs interne et externe à la cavité 9, permettant d'apporter une barrière supplémentaire et d'améliorer l'herméticité du scellement. La couche barrière 5 comprend de préférence un matériau diélectrique isolant. Cette couche supplémentaire peut, par exemple, être un oxyde, un nitrure ou un oxynitrure de silicium, un oxyde d'aluminium ou un oxyde de titane déposé par CVD, PECVD ou encore LPCVD. La couche barrière 5 est par exemple formée à l'aide de techniques de lithographie ou photolithographie. La couche barrière 5 a une épaisseur ou largeur suivant le plan des faces à assembler, de préférence comprise entre 1 et 10 microns.

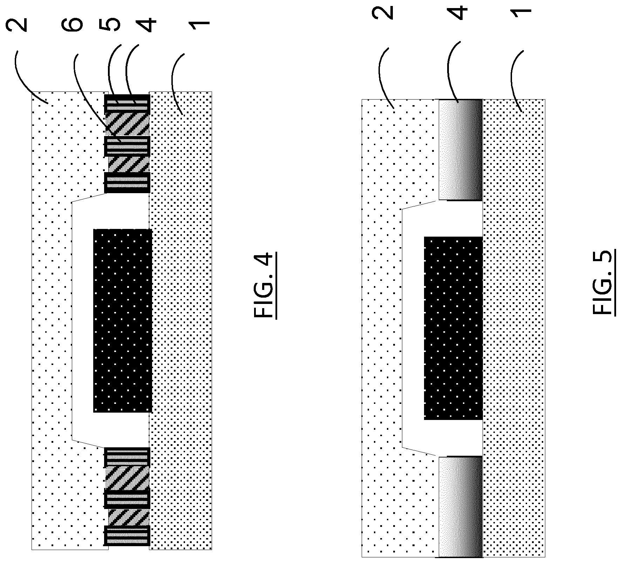

Selon un mode de réalisation illustré en **figure 4**, une couche barrière intermédiaire 6 est positionnée entre les deux portions (interne et externe) de la couche barrière 5 et/ou entre deux portions de la couche de scellement 4. Ainsi, le scellement est réalisé par une alternance de plusieurs motifs. La couche barrière intermédiaire 6 comprend de préférence un matériau diélectrique isolant. Cette couche barrière intermédiaire 6 peut, par exemple, être un oxyde, un nitrure ou un oxynitrure de silicium, un oxyde d'aluminium ou un oxyde de titane déposé par CVD, PECVD ou encore LPCVD. La couche barrière intermédiaire 6 est par exemple formée à l'aide de techniques de lithographie ou photolithographie. La couche barrière intermédiaire 6 a une épaisseur ou largeur suivant le plan des faces à assembler, de préférence comprise entre 1 et 10 microns.

La couche barrière 5 et la couche barrière intermédiaire 6 représentent avantageusement des piliers hermétiques de consolidation mécanique de l'empilement formé par le premier support 1 et le deuxième support 2. En raison de leurs propriétés barrières, ces cloisons garantissent une encapsulation latérale du composant 3. De par sa répartition géométrique, la couche de scellement 4 couvre, selon un mode de réalisation préféré, tout le périmètre périphérique défini par les dimensions du composant 3. Une telle disposition de la couche de scellement 4 contribue efficacement à une robustesse mécanique accrue de l'assemblage premier support 1 - deuxième support 2. De préférence, il n'y a pas d'espace entre la couche barrière 5 et/ou la couche barrière intermédiaire 6 et la couche de scellement 4.

Selon un exemple de réalisation non limitatif de l'invention, le premier support 1 est un substrat de verre, par exemple à base de borosilicate ou d'alumino-borosilicate.

On forme ensuite une couche de scellement 4, de formule LiₓP_{y}O_{z}N_{w} par une technique de pulvérisation réactive, à partir d'une cible de Li₃PO₄, sous un gaz 100% N₂, dans les conditions suivantes : débit N₂ de 100 sccm (centimètre cube standard par minute), densité de puissance radiofréquence (RF) de 4 watts/cm², température de dépôt de 150°C.

On dépose ensuite un deuxième support 2, par exemple un substrat en silicium. On procède ensuite à une mise en contact du premier support 1 et du deuxième support 2 afin de former une structure verre/silicium. Le collage anodique s'effectue ensuite à une tension de 100 volts, sous une température de 150°C.

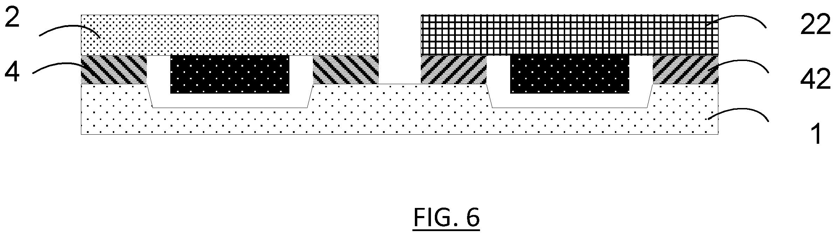

Les verres oxynitrures phosphorés peuvent présenter une variation du coefficient d'expansion thermique en fonction de leur composition, notamment en fonction du pourcentage atomique en azote. Cette caractéristique est mise en oeuvre dans les variantes illustrées sur les figures 5 et 6.

La **figure 5** illustre une première variante consistant à réaliser un gradient de composition en azote dans l'épaisseur de la couche de scellement 4 de formule LiₓP_{y}O_{z}N_{w} (par exemple en faisant varier le débit de N₂ au cours du dépôt dans le cas d'un procédé de dépôt sous vide). Par exemple, il a été montré qu'une augmentation du ratio N/P entraîne une diminution du coefficient d'expansion thermique de verres de type LiₓP_{y}O_{z}N_{w} (Journal of Non-Crystalline Solids 181 (1995) 201-214). Le coefficient d'expansion thermique peut par exemple diminuer de plus de 30% pour un rapport N/P passant de 0 à 0.8). Ce gradient de composition (qui se traduit par un gradient en termes de coefficient d'expansion thermique) peut atténuer les différences de coefficients d'expansion thermique entre deux substrats différents ayant lieu au cours du collage anodique. Selon ce mode de réalisation, l'un au moins parmi les paramètres x, y, z, w du composé LiₓP_{y}O_{z}N_{w} est évolutif dans l'épaisseur de la couche de scellement 4.

La **figure 6** illustre une deuxième variante consistant à réaliser une couche de scellement 4 qui présente au moins deux compositions différentes qui traduisent au moins deux coefficients d'expansion thermique différents sur deux zones différentes d'un support 1 (par exemple, le centre et la périphérie d'une plaque de silicium). Cette configuration permet de réaliser un collage anodique entre un premier support 1, un deuxième support 2 et un deuxième support additionnel 22. Selon un mode de réalisation, une première couche de scellement 4 assemble le premier support 1 avec un deuxième support 2 et une deuxième couche de scellement 42 assemble le premier support 1 avec un deuxième support additionnel 22. De préférence, la première couche de scellement 4 et la deuxième couche de scellement 42 ont des compositions chimiques différentes. Avantageusement, la deuxième couche de scellement 42 comprend au moins une couche d'un matériau conducteur ionique de formule LiₓP_{y}O_{z}N_{w}.

L'application d'une température et d'une tension adaptées permet de sceller, de façon pérenne, les différents dispositifs, réalisant de ce fait un ensemble hermétique et robuste avec une intégration qui offre une réduction de l'encombrement du packaging.

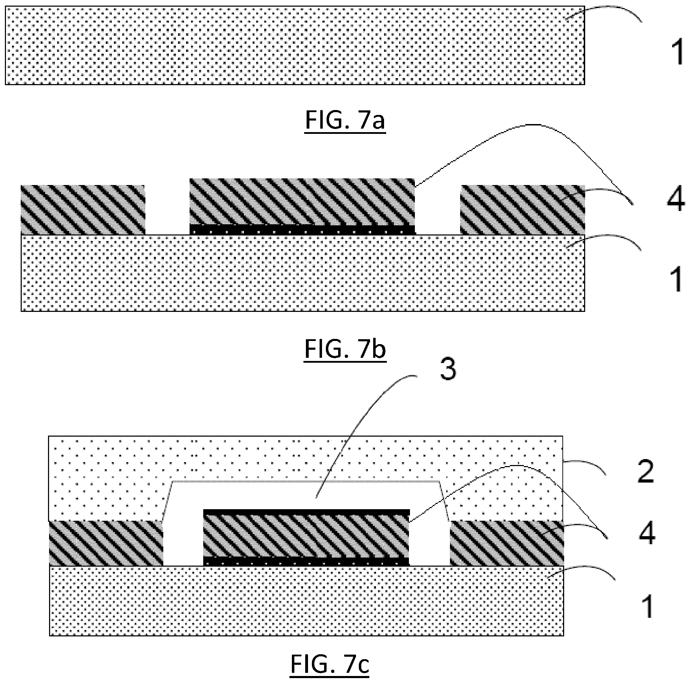

Les figures 7a à 7c illustrent un exemple particulier de réalisation dans lequel une couche LiₓP_{y}O_{z}N_{w} est commune à la zone de scellement et au composant électronique présent sur l'un des deux substrats (par exemple le substrat 1 comme en figure 7a)

Par exemple dans le cas d'une microbatterie ou d'un composant électrochrome, une couche LiₓP_{y}O_{z}N_{w} est présente dans l'empilement et joue le rôle de conducteur ionique. La couche LiₓP_{y}O_{z}N_{w} peut ainsi être déposée et structurée en une seule fois comme le montre la couche 4 déposée et ayant fait l'objet d'enlèvements de sorte à former les motifs souhaités (par tous moyens typiques notamment par lithographie ou photolithographie) et permettre ainsi un scellement visible en figure 7c avec un gain en termes de coût de procédé. Une portion de la couche LiₓP_{y}O_{z}N_{w} sert donc au scellement et au moins une autre sert à la formation du composant 3.

Les variantes ou options décrites dans cette partie découlent directement du descriptif des étapes technologiques précédentes. Elles sont valables pour les applications illustratives comme les micro-batteries mais peuvent être transposables sur d'autres composants microélectroniques. Sauf indication contraire, les étapes qui décrivent les exemples présentés dans chaque partie sont basées sur les mêmes principes précédemment énoncés. De manière particulièrement avantageuse, le procédé de collage selon la présente invention est adapté à des applications telles que le scellement hermétique de composants sensibles (en termes de résistance à la température et au champ électrique), par exemple, des microsystèmes électromécaniques (acronyme MEMS en anglais pour « Micro-Electro-Mechanical System »), des microbatteries, des composants électrochromes, des microcapteurs.

## Revendications

1. Dispositif microélectronique comprenant: un premier support (1), un deuxième support (2), des premières faces respectives des premier et deuxième supports (1, 2) étant disposées en regard, et une couche de scellement (4) entre lesdites premières faces,
**caractérisé en ce que** la couche de scellement (4) comprend au moins une couche d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1.

2. Dispositif selon la revendication précédente, dans lequel l'un au moins parmi le premier support (1) et le deuxième support (2) porte sur sa première face au moins un composant électronique (3).

3. Dispositif selon la revendication précédente, comprenant une cavité (9) hermétique délimitée par la première face du premier support (1), la première face du deuxième support (2) et la couche de scellement (4), ledit au moins composant électronique (3), étant encapsulé dans ladite cavité (9), le dispositif comprenant de préférence, dans la cavité (9), un élément absorbeur getter.

4. Dispositif selon l'une des deux revendications précédentes dans lequel le composant électronique (3) comporte une couche de LiₓP_{y}O_{z}N_{w} formée à partir d'une même couche d'un matériau conducteur ionique de formule LiₓP_{y}O_{z}N_{w} que la couche de scellement (4), de préférence pour former l'un parmi : une microbatterie, un composant électrochrome.

5. Dispositif selon l'une quelconque des revendications précédentes comprenant une couche barrière (5) ; au moins une portion de la couche barrière (5) étant disposée sur un flanc externe de la couche de scellement (4).

6. Dispositif selon l'une quelconque des revendications précédentes comprenant une couche barrière (5) et dans lequel au moins une portion de la couche barrière (5) est disposée sur un flanc interne de la couche de scellement (4).

7. Dispositif selon l'une quelconque des revendications précédentes comprenant une couche barrière intermédiaire (6) positionnée entre deux portions de la couche de scellement (4).

8. Dispositif selon l'une quelconque des revendications précédentes dans lequel l'un au moins parmi les paramètres x, y, z, w du composé LiₓP_{y}O_{z}N_{w} est évolutif dans l'épaisseur de la couche de scellement (4).

9. Dispositif selon la revendication précédente, dans lequel un gradient de composition w/y évolue d'une valeur minimale au niveau d'une interface de collage de la couche de scellement (4) en contact avec l'un parmi le premier et le deuxième supports (1, 2) ayant le coefficient d'expansion thermique le plus élevé vers une valeur maximale au niveau d'une interface de collage de la couche de scellement en contact avec l'autre support parmi le premier et le deuxième supports (1, 2) ayant le coefficient d'expansion le moins élevé.

10. Dispositif selon l'une quelconque des revendications précédentes dans comprenant une deuxième couche de scellement (42) pour assembler le premier support (1) avec un deuxième support additionnel (22); la deuxième couche de scellement (42) comprend au moins une couche d'un matériau conducteur ionique de formule Liₓ₁P_{y1}O_{z1}N_{w1}, avec x1 strictement supérieur à 0 et inférieur ou égal à 4.5, y1 strictement supérieur à 0 et inférieur ou égal à 1, z1 strictement supérieur à 0 et inférieur ou égal à 5.5, w1 supérieur ou égal à 0 et inférieur ou égal à 1, et de préférence dans lequel la couche de scellement (4) et la deuxième couche de scellement (42) ont des compositions chimiques différentes.

11. Procédé de réalisation d'un dispositif microélectronique comprenant un premier support (1), un deuxième support (2), des premières faces respectives des premier et deuxième supports (1, 2) étant disposées en regard, le procédé comprenant une étape de formation d'une couche de scellement (4) entre lesdites premières faces,
**caractérisé en ce que** la couche de scellement (4) comprend au moins une couche d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1.

12. Procédé selon la revendication précédente dans lequel, après la formation de la couche de scellement (4), on effectue un collage anodique en appliquant une tension inférieure à 100 volts et/ou une température inférieure à 150°C.

13. Procédé selon l'une quelconque des deux revendications précédentes dans lequel l'étape de formation de la couche de scellement est configurée de sorte à former une cavité (9) hermétique délimitée par la première face du premier support (1), la première face du deuxième support (2) et la couche de scellement (4), et de préférence dans lequel l'un au moins parmi le premier support (1) et le deuxième support (2) porte sur sa première face au moins un composant électronique (3), de sorte le composant (3) soit encapsulé dans ladite cavité (9).

14. Procédé selon l'une quelconque des trois revendications précédentes dans lequel l'un au moins parmi les paramètres x, y, z, w du composé LiₓP_{y}O_{z}N_{w} est évolutif dans l'épaisseur de la couche de scellement (4), et de préférence, dans lequel on forme un gradient de composition w/y qui évolue d'une valeur minimale au niveau d'une interface de collage de la couche de scellement (4) en contact avec l'un parmi le premier et le deuxième supports (1, 2) ayant le coefficient d'expansion thermique le plus élevé vers une valeur maximale au niveau d'une interface de collage de la couche de scellement en contact avec l'autre support parmi le premier et le deuxième supports (1, 2) ayant le coefficient d'expansion le moins élevé.

15. Utilisation d'un matériau conducteur ionique de formule LiₓP_{y}O_{z}N_{w}, avec x strictement supérieur à 0 et inférieur ou égal à 4.5, y strictement supérieur à 0 et inférieur ou égal à 1, z strictement supérieur à 0 et inférieur ou égal à 5.5, w supérieur ou égal à 0 et inférieur ou égal à 1, comme couche de scellement pour l'assemblage d'un premier support (1) et d'un deuxième support (2).

## Patentansprüche

1. Mikroelektronische Vorrichtung, enthaltend: einen ersten Träger (1), einen zweiten Träger (2), wobei jeweilige erste Seiten des ersten und des zweiten Träges (1, 2) gegenüberliegend angeordnet sind, sowie eine Versiegelungsschicht (4) zwischen den ersten Seiten,
**dadurch gekennzeichnet, dass** die Versiegelungsschicht (4) zumindest eine Schicht aus einem ionenleitenden Material der Formel LiₓP_{y}O_{z}N_{w} enthält, worin x strikt größer als 0 und kleiner oder gleich 4,5 ist, y strikt größer als 0 und kleiner oder gleich 1 ist, z strikt größer als 0 und kleiner oder gleich 5,5 ist, w größer oder gleich 0 und kleiner oder gleich 1 ist.

2. Vorrichtung nach dem vorangehenden Anspruch, wobei zumindest einer aus erstem Träger (1) und zweitem Träger (2) an seiner ersten Seite zumindest ein elektronisches Bauteil (3) trägt.

3. Vorrichtung nach dem vorangehenden Anspruch, enthaltend einen Hohlraum (9), der von der ersten Seite des ersten Trägers (1), der ersten Seite des zweiten Trägers (2) und der Versiegelungsschicht (4) hermetisch abgeschlossen wird, wobei das zumindest eine elektronische Bauteil (3) in dem Hohlraum (9) eingekapselt ist, wobei die Vorrichtung vorzugsweise in dem Hohlraum (9) ein absorbierendes Getterelement aufweist.

4. Vorrichtung nach einem der beiden vorangehenden Ansprüche, wobei das elektronische Bauteil (3) eine LiₓP_{y}O_{z}N_{w} - Schicht enthält, die ausgehend von einer gleichen Schicht eines ionenleitenden Materials der Formel LiₓP_{y}O_{z}N_{w} wie die Versiegelungsschicht (4) gebildet ist, um vorzugsweise eines aus Mikrobatterie und elektrochomem Bauteil zu bilden.

5. Vorrichtung nach einem der vorangehenden Ansprüche, enthaltend eine Barriereschicht (5); wobei zumindest ein Abschnitt der Barriereschicht (5) an einer Außenflanke der Versiegelungsschicht (4) angeordnet ist.

6. Vorrichtung nach einem der vorangehenden Ansprüche, enthaltend eine Barriereschicht (5), wobei zumindest ein Abschnitt der Barriereschicht (5) an einer Innenflanke der Versiegelungsschicht (4) angeordnet ist.

7. Vorrichtung nach einem der vorangehenden Ansprüche, enthaltend eine Zwischenbarriereschicht (6), die zwischen zwei Abschnitten der Versiegelungsschicht (4) positioniert ist.

8. Vorrichtung nach einem der vorangehenden Ansprüche, wobei zumindest einer der Parameter x, y, z, w der LiₓP_{y}O_{z}N_{w} - Verbindung in der Dicke der Versiegelungsschicht (4) evolutiv ist.

9. Vorrichtung nach dem vorangehenden Anspruch, wobei ein Gradient der w/y-Zusammensetzung von einem minimalen Wert im Bereich einer Bondingschnittstelle der Versiegelungsschicht (4) in Kontakt mit einem aus erstem und zweitem Träger (1, 2) mit höherem Wärmeausdehnungskoeffizienten auf einen maximalen Wert im Bereich einer Bondingschnittstelle der Versiegelungsschicht in Kontakt mit dem anderen aus erstem und zweitem Träger (1, 2) mit niedrigeren Wärmeausdehnungskoeffizienten übergeht.

10. Vorrichtung nach einem der vorangehenden Ansprüche, enthaltend eine zweite Versiegelungsschicht (42) zum Zusammenfügen des ersten Trägers (1) mit einem zusätzlichen zweiten Träger (22); wobei die zweite Versiegelungsschicht (42) zumindest eine Schicht aus einem ionenleitenden Material der Formel Liₓ₁P_{y1}O_{z1}N_{w1} enthält, worin x1 strikt größer als 0 und kleiner oder gleich 4,5 ist, y1 strikt größer als 0 und kleiner oder gleich 1 ist, z1 strikt größer als 0 und kleiner oder gleich 5,5 ist, w1 größer oder gleich 0 und kleiner oder gleich 1 ist, und wobei vorzugsweise die Versiegelungsschicht (4) und die zweite Versiegelungsschicht (42) unterschiedliche chemische Zusammensetzungen haben.

11. Verfahren zum Herstellen einer mikroelektronischen Vorrichtung, enthaltend einen ersten Träger (1), einen zweiten Träger (2), wobei jeweilige erste Seiten des ersten und des zweiten Träges (1, 2) gegenüberliegend angeordnet sind, wobei das Verfahren einen Schritt des Bildens einer Versiegelungsschicht (4) zwischen den ersten Seiten umfasst,
**dadurch gekennzeichnet, dass** die Versiegelungsschicht (4) zumindest eine Schicht aus einem ionenleitenden Material der Formel LiₓP_{y}O_{z}N_{w} enthält, worin x strikt größer als 0 und kleiner oder gleich 4,5 ist, y strikt größer als 0 und kleiner oder gleich 1 ist, z strikt größer als 0 und kleiner oder gleich 5,5 ist, w größer oder gleich 0 und kleiner oder gleich 1 ist.

12. Verfahren nach dem vorangehenden Anspruch, wobei nach dem Bilden der Versiegelungsschicht (4) ein anodisches Bonden erfolgt, indem eine Spannung unter 100 Volt und/oder eine Temperatur unter 150 °C angewendet wird.

13. Verfahren nach einem der beiden vorangehenden Ansprüche, wobei der Schritt des Bildens der Versiegelungsschicht so ausgelegt ist, dass ein Hohlraum (9) gebildet wird, der von der ersten Seite des ersten Trägers (1), der ersten Seite des zweiten Trägers (2) und der Versiegelungsschicht (4) hermetisch abgeschlossen wird, und wobei vorzugsweise zumindest einer aus erstem Träger (1) und zweitem Träger (2) an seiner ersten Seite zumindest ein elektronisches Bauteil (3) so trägt, dass das elektronische Bauteil (3) in dem Hohlraum (9) eingekapselt ist.

14. Verfahren nach einem der drei vorangehenden Ansprüche, wobei zumindest einer der Parameter x, y, z, w der LiₓP_{y}O_{z}N_{w}- Verbindung in der Dicke der Versiegelungsschicht (4) evolutiv ist, und wobei vorzugsweise ein Gradient der w/y-Zusammensetzung gebildet wird, der von einem minimalen Wert im Bereich einer Bondingschnittstelle der Versiegelungsschicht (4) in Kontakt mit einem aus erstem und zweitem Träger (1, 2) mit höherem Wärmeausdehnungskoeffizienten auf einen maximalen Wert im Bereich einer Bondingschnittstelle der Versiegelungsschicht in Kontakt mit dem anderen aus erstem und zweitem Träger (1, 2) mit niedrigeren Wärmeausdehnungskoeffizienten übergeht.

15. Verwendung eines ionenleitenden Materials der Formel LiₓP_{y}O_{z}N_{w}, worin x strikt größer als 0 und kleiner oder gleich 4,5 ist, y strikt größer als 0 und kleiner oder gleich 1 ist, z strikt größer als 0 und kleiner oder gleich 5,5 ist, w größer oder gleich 0 und kleiner oder gleich 1 ist, als Versiegelungsschicht zum Zusammenfügen von einem ersten Träger (1) und einem zweiten Träger (2).

## Claims

1. Microelectronic device comprising: a first support (1), a second support (2), first respective faces of the first and second supports (1, 2) being arranged facing each other, and a sealing layer (4) between said first faces, **characterised in that** the sealing layer (4) comprises at least one layer made of an ionic conductive material of formula LiₓP_{y}O_{z}N_{w}, with x strictly greater than 0 and less than or equal to 4.5, y strictly greater than 0 and less than or equal to 1, z strictly greater than 0 and less than or equal to 5.5, w greater than or equal to 0 and less than or equal to 1.

2. Device according to the preceding claim, wherein at least one from among the first support (1) and the second support (2) carries on the first face thereof, at least one electronic component (3).

3. Device according to the preceding claim, comprising a hermetic cavity (9) delimited by the first face of the first support (1), the first face of the second support (2) and the sealing layer (4), said at least one electronic component (3), being encapsulated in said cavity (9), the device preferably comprising, in the cavity (9), an absorbing getter element.

4. Device according to one of the two preceding claims, wherein the electronic component (3) comprises an LiₓP_{y}O_{z}N_{w} layer formed from one same layer made of an ionic conductive material of formula LiₓP_{y}O_{z}N_{w} as the sealing layer (4), preferably to form one from among: a microbattery, an electrochromic component.

5. Device according to any one of the preceding claims, comprising a barrier layer (5); at least one portion of the barrier layer (5) being arranged on an outer flank of the sealing layer (4).

6. Device according to any one of the preceding claims, comprising a barrier layer (5) and wherein at least one portion of the barrier layer (5) is arranged on an inner flank of the sealing layer (4).

7. Device according to any one of the preceding claims, comprising an intermediate barrier layer (6) positioned between two portions of the sealing layer (4).

8. Device according to any one of the preceding claims, wherein at least one from among the parameters x, y, z, w of the compound LiₓP_{y}O_{z}N_{w} develops in the thickness of the sealing layer (4).

9. Device according to the preceding claim, wherein a gradient of composition w/y develops from a minimum value at an adhering interface of the sealing layer (4) in contact with one from among the first and second supports (1, 2) having the highest heat expansion coefficient, to a maximum value at an adhering interface of the sealing layer in contact with the other support from among the first and second supports (1, 2) having the lowest expansion coefficient.

10. Device according to any one of the preceding claims, comprising a second sealing layer (42) to assemble the first support (1) with a second additional support (22); the second sealing support (42) comprises at least one layer made of an ionic conductive material of formula Liₓ₁P_{y1}O_{z1}N_{w1}, with x1 strictly greater than 0 and less than or equal to 4.5, y1 strictly greater than 0 and less than or equal to 1, z1 strictly greater than 0 and less than or equal to 5.5, w1 greater than or equal to 0 and less than or equal to 1, and preferably wherein the sealing layer (4) and the second sealing layer (42) have different chemical compositions.

11. Method for producing a microelectronic device, comprising a first support (1), a second support (2), first respective faces of the first and second supports (1, 2) being arranged facing each other, the method comprising a step of forming a sealing layer (4) between said first faces, **characterised in that** the sealing layer (4) comprises at least one layer made of an ionic conductive material of formula LiₓP_{y}O_{z}N_{w}, with x strictly greater than 0 and less than or equal to 4.5, y strictly greater than 0 and less than or equal to 1, z strictly greater than 0 and less than or equal to 5.5, w greater than or equal to 0 and less than or equal to 1.

12. Method according to the preceding claim, wherein, after the formation of the sealing layer (4), an anodic adhesion is made by applying a voltage of less than 100 volts and/or a temperature of less than 150°C.

13. Method according to any one of the two preceding claims, wherein the step of forming the sealing layer is configured so as to form a hermetic cavity (9) delimited by the first face of the first support (1), the first face of the second support (2) and the sealing layer (4), and preferably wherein at least one from among the first support (1) and the second support (2) carries on the first face thereof, at least one electronic component (3), such that the component (3) is encapsulated in said cavity (9).

14. Method according to any one of the three preceding claims, wherein at least from among the parameters x, y, z, w of the compound LiₓP_{y}O_{z}N_{w} develops in the thickness of the sealing layer (4), and preferably, wherein a gradient of composition w/y is formed, which develops from a minimum value at an adhering interface of the sealing layer (4) in contact with one from among the first and second supports (1, 2) having the highest heat expansion coefficient, to a maximum value at an adhering interface of the sealing layer in contact with the other support from among the first and second supports (1, 2) having the lowest expansion coefficient.

15. Use of an ionic conductive material of formula LiₓP_{y}O_{z}N_{w}, with x strictly greater than 0 and less than or equal to 4.5, y strictly greater than 0 and less than or equal to 1, z strictly greater than 0 and less than or equal to 5.5, w greater than or equal to 0 and less than or equal to 1, as a sealing layer for assembling a first support (1) and a second support (2).
